Europäisches Patentamt

European Patent Office

Office européen des brevets

(19)

(11) **EP 1 125 347 B1**

(12) **FASCICULE DE BREVET EUROPEEN**

(45) Date de publication et mention
de la délivrance du brevet:
**29.01.2003 Bulletin 2003/05**

(21) Numéro de dépôt: **99950876.5**

(22) Date de dépôt: **28.10.1999**

(51) Int Cl.⁷: $H01S\ 3/108$, $H01S\ 3/083$

(86) Numéro de dépôt international:
**PCT/FR99/02644**

(87) Numéro de publication internationale:
**WO 00/025396 (04.05.2000 Gazette 2000/18)**

(54) **FILTRES AUTO-ADAPTES POUR L'AFFINEMENT DE L'EMISSION LASER**

AUTO-ADAPTIERTE FILTER ZUR VERFEINERUNG DER LASEREMISSION

SELF-ADAPTED FILTERS FOR SHARPENING LASER EMISSION

(84) Etats contractants désignés:
**DE FR GB IT NL**

(30) Priorité: **28.10.1998 FR 9813525**

(43) Date de publication de la demande:
**22.08.2001 Bulletin 2001/34**

(73) Titulaire: **CENTRE NATIONAL DE
LA RECHERCHE SCIENTIFIQUE (CNRS)
75794 Paris Cedex 16 (FR)**

(72) Inventeurs:
 • **ROOSEN, Gérald;
 Lab. C. Fabry de l'Ins. d'Optiqe
 F-91403 Orsay Cedex (FR)**
 • **BRUN, Alain; Lab. C. Fabry de l'Inst. d'Optique
 F-91403 Orsay Cedex (FR)**
 • **HUOT, Nicolas; Lab. C. Fabry de l'Inst. d'Optique
 F-91403 Orsay Cedex (FR)**
 • **JONATHAN, Jean-M.
 Lab. C. Fabry de l'Ins. d'Optiq
 F-91403Orsay Cedex (FR)**
 • **PAULIAT, Gilles
 Lab. C. Fabry de l'Inst. d'Optique
 F-91403 OrsayCedex (FR)**
 • **GEORGES, Patrick
 Lab. C. Fabry de l'Inst. d'Optiqe
 F-91403 Orsay Cedex (FR)**

(74) Mandataire: **Breese, Pierre
Breese - Majerowicz - Simonnot
3, avenue de l'Opéra
75001 Paris (FR)**

(56) Documents cités:

**EP-A- 0 433 122**

 • WHITTEN W B ET AL: "MODE SELECTION IN A
 CONTINUOUS-WAVE DYE LASER WITH AN
 INTRACAVITY PHOTOREFRACTIVE ELEMENT"
 OPTICS LETTERS, vol. 12, no. 2, 1 février 1987
 (1987-02-01), pages 117-119, XP000710524 ISSN:
 0146-9592
 • CRONIN-GOLOMB M ET AL: "SELF-INDUCED
 FREQUENCY SCANNING AND DISTRIBUTED
 BRAGG REFLECTION IN SEMICONDUCTOR
 LASERS WITH PHASE-CONJUGATE
 FEEDBACK" OPTICS LETTERS, vol. 11, no. 7, 1
 juillet 1986 (1986-07-01), pages 455-457,
 XP000710397 ISSN: 0146-9592
 • MILTENYI E ET AL: "LONG-TERM STABLE
 MODE LOCKING OF A VISIBLE DIODE LASER
 WITH PHASE -CONJUGATE FEEDBACK"
 OPTICS LETTERS, vol. 20, no. 7, 1 avril 1995
 (1995-04-01), pages 734-736, XP000497434 ISSN:
 0146-9592
 • SHIRATORI A ET AL: "WAVELENGHT-STABLE,
 NARROW-SPECTRAL-WIDTH OSCILLATION OF
 AN ALGAINP DIODE LASER COUPLED TO A
 BATIO3:CO STIMULATED PHOTOREFRACTIVE
 BACKSCATTERING PHASE CONJUGATOR"
 APPLIED PHYSICS B: LASERS AND OPTICS,
 vol. B65, no. 3, 1 septembre 1997 (1997-09-01),
 pages 329-333, XP000699346 ISSN: 0946-2171
 cité dans la demande
 • CHOMSKY D ET AL: "LASER FREQUENCY
 BANDWIDTH NARROWING BY
 PHOTOREFRACTIVE TWO-BEAM COUPLING"
 OPTICS LETTERS, vol. 17, no. 7, 1 avril 1992
 (1992-04-01), pages 481-483, XP000262590 ISSN:
 0146-9592

**Description**

La présente invention concerne une source de rayonnement lumineux cohérent de type laser. Elle concerne plus particulièrement la réduction du nombre de modes longitudinaux et/ou transverses (affinement spectral et/ou spatial) d'une telle source .

Pour réduire la largeur de raie d'émission d'un laser, on a proposé dans l'art, des éléments sélectifs nécessitant un réglage, tels que filtres de Lyot et de Fabry-Perot.

Plusieurs dispositifs d'affinement spectral ont été publiés ou brevetés.

On connaît par exemple dans l'art antérieur le brevet européen EP284908 décrivant un dispositif pour commander ou régler une longueur d'onde d'émission λe et une puissance optique émise d'un laser à semiconducteur. La puissance optique émise par le laser est envoyée au moins en partie à un dispositif détecteur opto-électrique et au moins à un dispositif de filtrage optique sélectif du point de vue des longueurs d'onde. Une partie de la puissance envoyée à ce dispositif de filtrage est transmise à un autre dispositif détecteur opto-électrique. Selon cet état de la technique, le laser à semiconducteur, le dispositif de filtre et les détecteurs sont intégrés sur un substrat commun. Le dispositif de filtre intégré est constitué par un réseau de Bragg ou par un coupleur directionnel ou un filtre interférentiel ou par un ensemble formé par deux ou plusieurs réseaux de Bragg disposés les uns derrière les autres dans la direction de propagation de la puissance envoyée et/ou par des coupleurs optiques directionnels et/ou par des filtres interférentiels.

On a proposé dans l'état de la technique des dispositifs sélectifs en longueur d'onde situés dans la cavité laser mais non auto-adaptables. L'article "82 nm of continuous tunability for an external cavity semiconductor laser" paru dans Electron. Lett. 27, 183 (1991) décrit un procédé d'affinement et de stabilisation d'une diode laser en cavité étendue utilisant un réseau de diffraction conventionnel. Le réseau de diffraction est un élément sélectif de la cavité étendue. Les deux facteurs qui contribuent à l'affinement sont la dispersion du réseau et la longueur de la cavité étendue qui réduit la largeur de Shalow-Townes de la raie émise.

On connaît également des diodes laser de type DFB (distributed feedback) ou DBR (distributed bragg reflector) intégrant un réseau de Bragg dans la zone active (DFB) ou en guise de miroir de cavité (DBR). Ces miroirs de Bragg ne sont pas auto-adaptables .

On connaît, dans l'état de la technique, différentes solutions pour la stabilisation spectrale d'un laser par recours à une cavité externe. Le brevet américain US4907237 décrit un procédé de stabilisation d'une diode laser grâce à une cavité externe possédant une fréquence de résonance particulière. Une partie du faisceau de sortie de la cavité externe est réinjectée dans la cavité laser.

On a encore proposé dans l'art antérieur des systèmes externes d'affinement auto-adaptables . L'article "Wavelength-stable, narrow-spectral-width oscillation of an AlGaInP diode laser coupled to a BaTiO$_3$:Co stimulated photorefractive backscattering phase conjugator" paru dans Appl. pays. B 65, 329 (1597) décrit un laser mettant en oeuvre un miroir à conjugaison de phase utilisant la sélectivité de Bragg des réseaux par réflexion et réinjectant une partie du faisceau dans la cavité laser. Le dispositif comporte un cristal placé en dehors de la cavité. La relation de phase est donc fixée.

On connaît aussi le brevet EP433122 décrivant un dispositif laser à cavité en anneau. Il s'agit d'injection de lumière à partir d'un laser maître vers un laser esclave qui hérite ainsi des propriétés de cohérence du laser maître. La présence du matériau photosensible ne modifie pas les propriétés spectrales du laser maître car il n'y a aucun retour de la cavité esclave vers la cavité maître.

L'article "Laser frequency bandwidth narrowing by photorefractive two-beam coupling" publié dans Opt. Lett. 17, 481, (1992) décrit un filtrage de la fréquence du faisceau à la sortie du laser par un réseau photoréfractif inscrit par les faisceaux sortant de la cavité laser.

Le document OPTICS LETTERS, Vol. 12, N° 2, 1er février 1987, pages 117-119, auteurs Whitten et al. « Mode selection in a continuous-wave dye laser with an intracavity photoreactive élément » décrit une source de rayonnement lumineux cohérent comprenant une cavité résonnante linéaire et un milieu amplificateur placé dans la cavité résonante, ainsi qu'un matériau photosensible dynamique placé dans la cavité résonante pour former un filtre spectral et/ou spatial autoadaptable.

Les dispositifs de l'art antérieur présentent différents inconvénients. Lorsque les caractéristiques de la cavité varient, par exemple par une modification de la longueur en raison de variations thermiques, l'efficacité des filtres interférentiels proposés dans certains dispositifs de l'art antérieur se dégrade.

Les solutions consistant à mettre en oeuvre un moyen externe nécessitent souvent des réglages délicats et sont sensibles aux efforts mécaniques.

Pour remédier à ces inconvénients, l'invention concerne dans son acception la plus générale une source de rayonnement lumineux cohérent de type laser, selon la revendication 1.

L'invention est basée sur l'inscription, dans le matériau photosensible dynamique, d'un réseau par la structure d'ondes de la cavité. La sélectivité de ce réseau associé à un ou plusieurs miroirs de la cavité convenablement choisis, réalise un filtre automatiquement adapté et permet donc, en utilisant la compétition entre modes, d'améliorer la cohérence temporelle et spatiale de la lumière émise, tout en conservant les possibilités préexistantes de changement de longueur d'onde.

Ce filtre module automatiquement de manière différente les pertes pour chacun des modes possibles de la cavité et la force à n'osciller que sur un seul ou un petit nombre de ces modes. L'adaptation s'effectue au travers de l'inscription par le faisceau oscillant dans la cavité d'un réseau ou d'un hologramme dans un matériau photosensible dynamique. Elle résulte de la réponse particulière du matériau photosensible dynamique choisi qui ne répond qu'à des réseaux d'interférence (variation spatiale de l'intensité ou de l'état de polarisation de la lumière).

Avantageusement, le matériau photosensible dynamique est constitué par un matériau photoréfractif. Ces matériaux sont sensibles au gradient de l'illumination.

D'autres matériaux dont les variations d'indice, d'absorption ou d'anisotropie proviennent par exemple d'un transfert de matière peuvent convenir. Avec ce type de réponse, l'écriture d'un hologramme adapté à un mode efface les hologrammes inscrits par les autres modes.

Selon une variante préférée, le matériau photosensible dynamique est sensible aux variations spatiales des caractéristiques d'illumination (intensité ou polarisation).

Selon un mode de réalisation particulier, le matériau photosensible dynamique est formé par une pluralité de lames et placé dans la cavité résonante pour former un filtre spectral et/ou spatial auto-adaptable .

Selon l'invention, la cavité est une cavité laser en anneau et en ce que le matériau photosensible dynamique est placé à l'intersection de deux faisceaux croisés.

Selon un exemple de réalisation, le matériau photoréfractif dynamique est constitué par un cristal de titanate de baryum.

Les principaux avantages de l'invention sont l'absence de réglage et le fait que le fonctionnement est auto-adaptable.

L'invention proposée évite avantageusement l'usage d'interféromètres de Fabry-Perot pour sélectionner finement la longueur d'onde. Elle est applicable à un grand nombre de lasers, y compris diodes laser et micro-lasers, aussi bien impulsionnels que continus à toutes les longueurs d'onde où l'on trouvera des matériaux photosensibles dynamiques convenables par leur sensibilité, tenue au flux at autres propriétés nécessaires au fonctionnement du dispositif.

L'invention sera mieux comprise à la lecture de la description qui suit, se référant aux dessins annexés où :

- la figure 1 représente une vue schématique d'une réalisation connue ;
- la figure 2 représente une vue schématique d'une variante de réalisation selon l'invention ;
- la figure 3 représente un schéma du montage d'une installation comprenant un dispositif utile à la compréhension de l'invention ;

- la figure 4 représente l'évolution du rapport entre l'énergie intra-cavité et l'énergie de sortie du laser en fonction du temps pour différentes énergies de sortie à l'état stationnaire ;
- la figure 5 représente la courbe de stabilité en énergie du rapport S2/S1 au cours du temps, dès l'état stationnaire (courbe de gauche) et après une période de fonctionnement de 10 minutes (courbe de droite) ;
- la figure 6 représente les franges de coin d'air pour deux différences de marche ;
- la figure 7 représente les interférogrammes obtenus avec et sans cristal photoréfractif ;
- la figure 8 représente un interférogramme mettant en évidence le fonctionnement bimode du laser.
- la figure 9, représente une vue schématique d'une variante de réalisation d'un dispositif utile à la compréhension de l'invention.

Le dispositif est élaboré autour d'un matériau dynamique (1) photosensible à la longueur d'onde utilisée.

Pour assurer l'auto-adaptation sélective à un mode particulier, ce matériau ne doit être sensible qu'aux variations spatiales des caractéristiques de la figure d'illumination (intensité, polarisation locale...) et non pas à ses composantes uniformes. C'est typiquement le cas dans les matériaux dont la variation d'indice ou d'absorption est principalement fonction du taux de modulation $m_i$ de la figure d'interférence à laquelle ils sont exposés :

$$m_j = \frac{I_i}{I_i + \sum_{i \neq j} I_j}$$

L'intensité $I_i$ du mode i ainsi que l'efficacité de diffraction de l'hologramme ou réseau associé augmentent avec $m_i$. Cela diminue les autres taux de modulation $m_j$ et l'efficacité de diffraction des hologrammes qui leur sont associés.

Le matériau photosensible dynamique est le coeur du dispositif qui réagit de telle sorte que son auto-adaptation à un mode $n°i$, ou à un petit nombre de modes, augmente le rapport :

$$R = \frac{\text{pertes pour un quelconque autre mode}}{\text{pertes pour ce mode } n°i}$$

Soit il diminue davantage les pertes pour ce mode que pour les autres, soit il ne change pas les pertes pour ce mode et les augmente pour tous les autres.

La diminution des pertes pour ce mode, et/ou l'augmentation des pertes pour les autres modes, est définie par la position de ce matériau photosensible dynamique dans le dispositif qui est constitué de ce matériau photosensible et de composants optiques habituels des cavités tels que des miroirs.

Plusieurs classes de matériaux photosensibles dynamiques peuvent convenir, par exemple

- les matériaux photoréfractifs ;
- les matériaux dans lesquels l'inscription de l'hologramme résulte d'une redistribution de centres absorbants. On peut citer la variation d'absorption observée dans certains cristaux photoréfractifs qui est liée à la redistribution de charges électriques ou la variation d'absorption et d'indice, qui pourrait provenir dans d'autres matériaux, d'un transfert de matière dans le gradient d'illumination. Ces matériaux peuvent être minces ou épais, homogènes ou structurés. Une épaisseur élevée peut être avantageusement utilisée pour renforcer la sélectivité du filtre auto-adapté. Dans le cas de matériaux minces, plusieurs échantillons espacés peuvent également renforcer cette sélectivité.

Suivant le type d'hologrammes inscrits (d'absorption ou d'indice), différents dispositifs peuvent être envisagés. De même, de multiples structures sont réalisables selon la géométrie de la cavité. À titre d'exemple, citons les dispositifs suivants :

Pour un matériau photoréfractif utilisé en régime de diffusion, l'hologramme induit est un hologramme d'indice qui est en quadrature par rapport à la figure d'illumination.

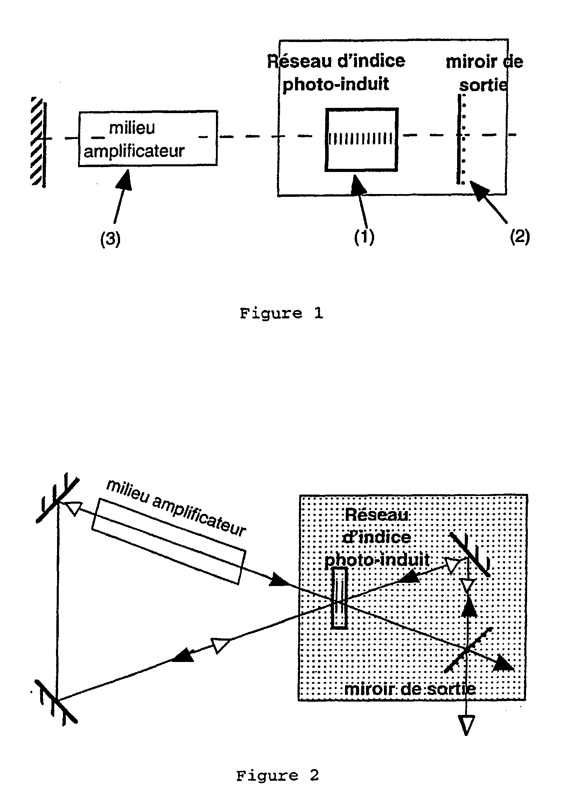

Une géométrie représentée sur la figure 1, décrit l'état de la technique avec une cavité linéaire. Le dispositif est représenté dans le rectangle grisé. Il est composé du matériau photoréfractif (1) et du miroir de sortie (2) de la cavité. Le réseau inscrit dans le matériau photoréfractif par les ondes stationnaires de la cavité, constitue un miroir de Bragg. Associé au miroir de sortie (2), il définit un filtre de Fabry-Perot adapté au mode qui a inscrit le réseau ou l'hologramme. On place le matériau photoréfractif pour que le sens du décalage entre le réseau d'illumination et le réseau d'indice confère à ce filtre Fabry-Perot un maximum de réflectivité pour le mode ayant inscrit l'hologramme. La réflectivité du dispositif augmente pour ce mode, donc les pertes diminuent et l'oscillation est favorisée. La sélectivité introduite est fonction de la distance entre le matériau et le miroir, et de l'épaisseur du matériau.

Le miroir est de préférence collé contre le milieu amplificateur, l'ensemble formant un microlaser.

Le matériau est inséré entre le milieu amplificateur (3) et le miroir de sortie (2). L'hologramme inscrit par les ondes stationnaires correspondant à un mode de la cavité est un miroir de Bragg qui réfléchit partiellement chacune des deux ondes contre-propageantes. Dans l'exemple décrit, le matériau holographique (1) est constitué par un cristal photoréfractif de titanate de baryum.

La réponse du dispositif, alliée à celle d'un milieu amplificateur laser à raie homogène, entraîne une compétition entre les modes et force la cavité laser à n'osciller que sur un mode ou un petit nombre de modes.

Dans le cas d'un milieu amplificateur laser à raie inhomogène, les pertes induites sur les autres modes doivent être suffisamment importantes pour amener ces modes en dessous du seuil d'oscillation de la cavité et ainsi affiner spectralement et/ou spatialement l'émission laser.

L'auto-adaptation est ici réalisée par l'inscription au sein d'un matériau photosensible dynamique approprié, d'un hologramme induit par un ou quelques modes du laser.

Une variante de réalisation selon l'invention dans laquelle la cavité laser est en anneau est illustrée sur le schéma de la figure 2. Le dispositif, dans le rectangle grisé, est formé du matériau et de deux miroirs dont le miroir de sortie. Le réseau ou hologramme est, comme dans le cas précédent, inscrit par les interférences qui existent dans la cavité.

Le réseau est inscrit par toutes les ondes qui interfèrent dans le matériau photoréfractif. Celui-ci est orienté de sorte que la réflectivité du dispositif augmente pour le mode ayant inscrit l'hologramme. Dans certains cas, le dispositif peut aussi remplir la fonction de diode optique (le laser n'oscille que dans un sens).

Pour un hologramme de transparence induite, le dispositif est constitué du matériau photosensible dynamique et de l'un quelconque des miroirs de la cavité. Les deux faisceaux contrepropageants créent un réseau de transparence qui est en phase avec la figure d'illumination, ce qui diminue les pertes pour ce mode. À l'état stationnaire, les centres absorbants sont préférentiellement dans les franges sombres de la figure d'illumination du mode favorisé ce qui en retour augmente les pertes pour les autres modes.

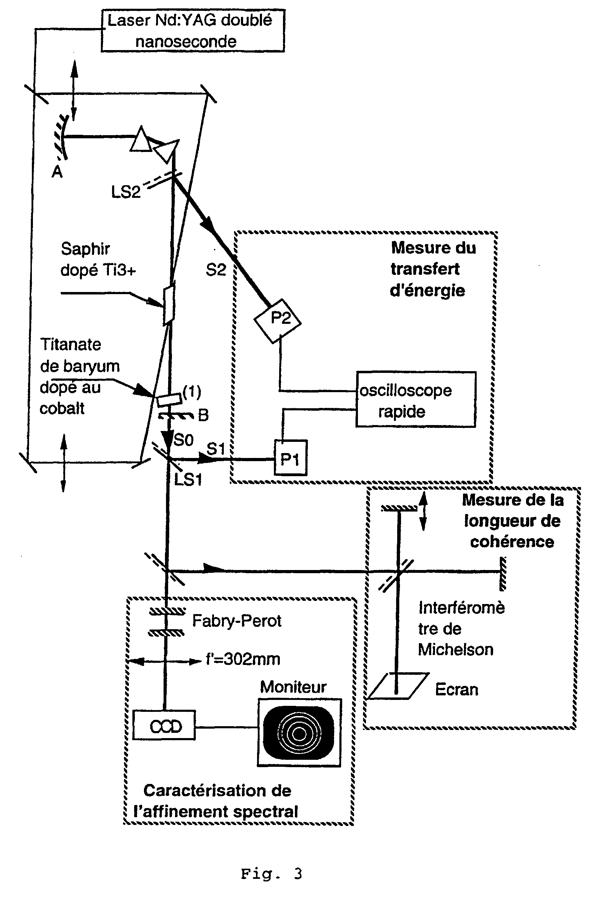

La figure 3 représente, un schéma du montage d'une installation comprenant un dispositif utile à la compréhension de l'invention et les systèmes de contrôle qui ont permis d'en vérifier le fonctionnement. Le laser est un laser à saphir dopé au titane pompé à une cadence de 10Hz par un laser Nd:YAG nanoseconde doublé en fréquence. Il émet des impulsions de durée 50ns en régime de déclenchement par le gain. Son accordabilité est assurée par deux prismes ajustables. Il n'y a pas de filtre Fabry-Perot dans la cavité de sorte que le spectre obtenu s'étale sur 0,7nm environ. L'homogénéité de la raie autorise la compétition entre modes. La cavité laser d'origine commerciale a une longueur de 60 cm. Le miroir de sortie (miroir B) a un coefficient de réflexion de 60% et transmet la sortie S0.

Le matériau photosensible dynamique (1) a été placé à une distance pouvant varier de 1mm à quelques centimètres du miroir de sortie (B), en raison de l'espace disponible dans ce laser particulier. Le miroir (B) aurait pu être déposé sur le cristal, selon une variante de réalisation. En raison de la longueur d'onde d'émission de ce laser, il a été choisi parmi les matériaux disponibles un cristal photoréfractif de titanate de baryum dopé au cobalt, coupé à 45° de l'axe optique, présentant une absorption de l'ordre de 0,2cm$^{-1}$ vers 750nm et d'épaisseur 2 mm. Cela a permis de repousser les problèmes de dommage optique tout en profitant du maximum de gain du cristal laser à saphir dopé au titane (autour de 780nm). Cela définit la longueur d'onde de travail à 760nm.

Pour tester le fonctionnement du dispositif, trois systèmes ont été mis en place :

- une lame de verre LS2 placée devant les prismes extrait une partie du faisceau intracavité (sortie S2). Une seconde lame LS1 extrait une partie du faisceau en sortie S0 (signal S1). Deux photodiodes rapides P1 et P2 sur les sorties S1 et S2 permettent d'observer l'accumulation d'énergie dans la cavité laser, résultant de l'augmentation de réflectivité due au filtre auto-adapté ;
- un interféromètre de Fabry-Perot plan permet de visualiser les anneaux d'interférences multiples et donc d'observer l'affinement spectral du laser ;
- un interféromètre de Michelson permet d'apprécier la longueur de cohérence de la source laser.

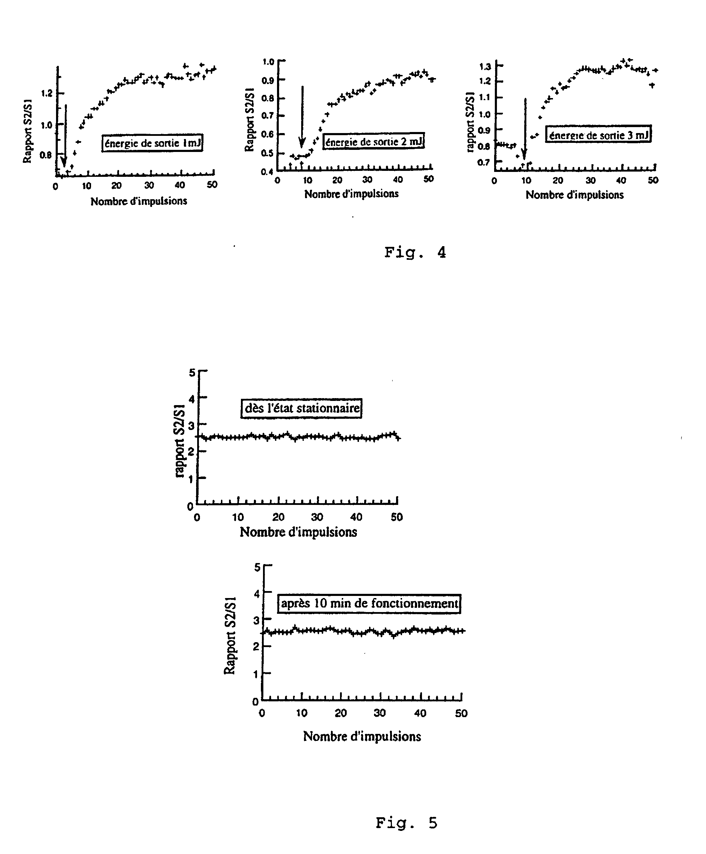

L'accumulation d'énergie dans la cavité laser est étudiée en mesurant l'évolution du rapport des énergies mesurées en S2 et S1. Sur les premières impulsions émises par le laser, on observe l'augmentation recherchée du rapport des énergies (figure 4). Cependant, elle pourrait être attribuée à l'établissement de l'équilibre thermique dans le milieu laser. Pour être certain d'avoir atteint cet équilibre thermique, on attend quelques secondes, puis on modifie rapidement la longueur d'onde d'émission du laser en tournant légèrement le miroir de fond de cavité A. Le réseau précédemment inscrit est inefficace car il n'est plus adapté au nouveau mode de fonctionnement du laser. Un transfert progressif d'énergie s'établit de S1 vers S2, au fur et à mesure de la création d'un nouveau réseau et de l'effacement du précédent. L'expérience démontre aussi que l'accordabilité du laser est préservée. L'expérience a été reproduite pour des énergies de sortie à l'état stationnaire de 1 mJ, 2 mJ, 3 mJ. Sur la figure 4., les flèches représentent les moments où l'on fait varier la longueur d'onde du laser.

On constate sur les trois courbes un accroissement du rapport S2/S1. On trouve respectivement des rapports égaux à 1,96, 2 et 1,86 pour les différentes énergies de sortie à l'état stationnaire. La mise hors de cause des effets thermiques implique que le composant est efficace et que la réflectivité du composant augmente avec le temps pour atteindre un état stationnaire. À partir de cette variation du rapport entre l'état initial et l'état stationnaire, on peut montrer que dans ces conditions et à la longueur d'onde d'accord de Bragg, la réflectivité du composant est passée de 60% à 75% et que le réseau photoinduit a une réflectivité de 7,5% à l'état stationnaire. En accord avec le temps d'écriture d'un réseau photoréfractif pour une énergie sur le cristal de l'ordre de 7 mJ et pour un diamètre de faisceau de l'ordre de 2 mm, l'effet s'établit en une dizaine d'impulsions.

La stabilité en énergie de l'efficacité du composant a été vérifiée par l'enregistrement sur 50 impulsions du rapport S2/S1 après que l'état stationnaire ait été atteint. Après 10 minutes de fonctionnement, la mesure a été recommencée. On constate sur la figure 5, que le rapport S2/S1 est inchangé à ±3%.

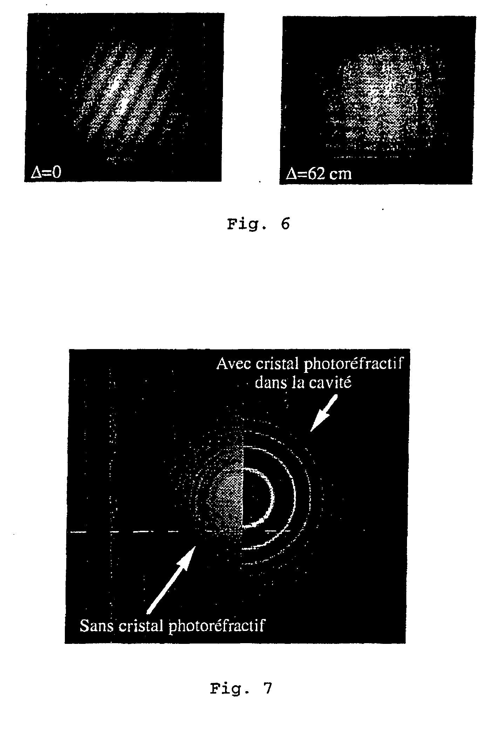

Un interféromètre de Michelson , représenté en figure 3 et dont on fait varier la différence de marche $\Delta$ entre les deux bras, permet de vérifier que ce transfert d'énergie s'accompagne d'une augmentation de la longueur de cohérence de la source. Sans cristal photoréfractif dans la cavité laser, elle est de l'ordre de 1 mm, en accord avec une largeur spectrale de l'ordre de 0,7 nm. En plaçant le cristal photoréfractif dans la cavité laser, à une distance du miroir de sortie de 1 mm, une longueur de cohérence supérieure à 60 cm a été mesurée. Les interférogrammes correspondant au fonctionnement avec cristal photoréfractif et pour des différences de marche égales à $\Delta$=0 et $\Delta$=62 cm sont reproduits sur la figure 6. Si l'on règle l'interféromètre de Michelson à une différence de marche $\Delta$ bien supérieure au mm, et que l'on change légèrement la longueur d'onde d'émission du laser, les franges de l'interférogramme (franges de coin d'air) disparaissent (le dispositif réseau photoinduit plus miroir de sortie est désadapté. Elles réapparaissent en 1 à 2 secondes (un nouveau réseau photoinduit adapté s'est construit). La cinétique de ce processus est cohérente avec les constantes de temps d'accumulation d'énergie mesurées précédemment. Cette mesure permet d'affirmer que la largeur de la raie laser a été réduite de 300 GHz à moins de 1 GHz.

L'affinement spectral est observable en utilisant un interféromètre de Fabry-Perot plan d'épaisseur 3 mm (intervalle spectral libre de 50 GHz) et l'affinement spectral est visualisé par une diminution du nombre d'anneaux. Sont juxtaposés sur une même image (figure 7), à gauche l'interférogramme obtenu sans cristal photoréfractif dans la cavité laser et à droite, celui obtenu lorsque le cristal photoréfractif est placé à 1 mm du miroir de sortie . L'affinement spectral est clairement démontré. Ce résultat confirme que la raie obtenue à une largeur de l'ordre du GHz.

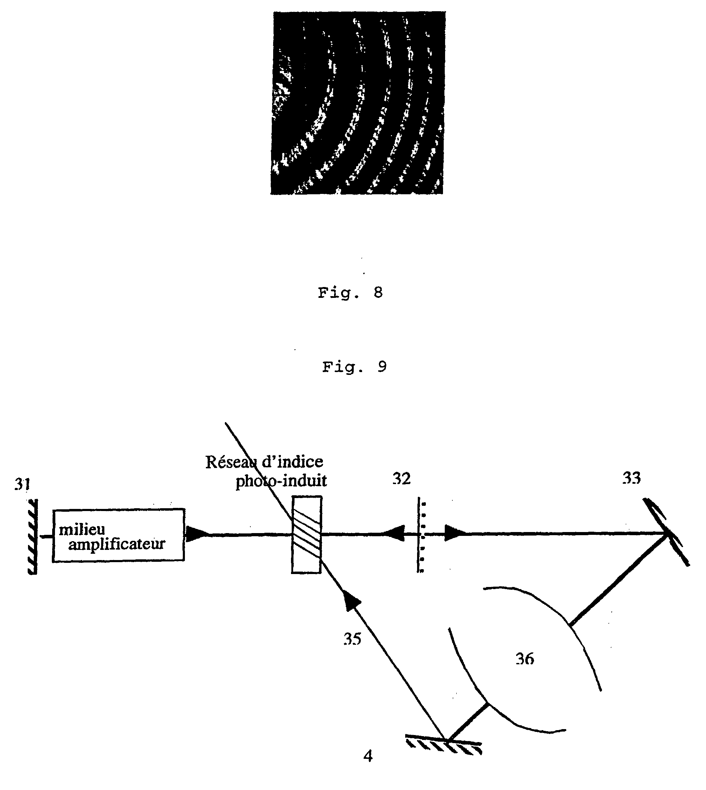

Pour une résolution inférieure à 1 GHz susceptible de résoudre la structure de ces anneaux, les miroirs de l'interféromètre de Fabry-Perot ont été écartés jusqu'à 6,6 cm (intervalle spectral libre de 2,5 GHz). Pour une distance d entre le cristal photoréfractif et le miroir arrière comprise entre 1 mm et 8 cm, un comportement bimode longitudinal a été observé. La figure 8 représente l'interférogramme obtenu avec l'interféromètre de Fabry-Perot de 6,6 cm pour une distance d=4 cm et illustre le fonctionnement bimode du laser.

Comme prévu, l'invention proposée réduit la largeur spectrale du laser. De plus, elle ne requiert aucun réglage fin. Il faut simplement placer approximativement le cristal photoréfractif pour que l'ensemble cristal miroir de sortie voit sa réflectivité augmenter.

Le dispositif selon l'invention possède une finesse comparable à celle des dispositifs réglables habituels mais possède en plus des propriétés d'auto-adaptabilité qui lui confèrent son intérêt. L'intérêt du dispositif est grand pour les sources accordables en longueur d'onde. Le réglage en longueur d'onde par les dispositifs habituels (filtre de Lyot, réseaux, prismes, ...) peut s'effectuer selon l'invention ; la largeur de raie est automatiquement réduite par le dispositif quelle que soit la longueur d'onde choisie. Il suffit pour cela que le matériau soit photosensible sur une gamme de longueurs d'onde suffisamment large.

Sans élément intra-cavité autre que le milieu amplificateur lui-même, l'émission laser est généralement multimode. Pour affiner spectralement l'émission laser, on utilise des interféromètres de Fabry-Perot couplés à des filtres biréfringents ou à des prismes. Ces dispositifs sont complexes à utiliser et ne sont pas auto-adaptables.

Pour des études de spectroscopie, il est nécessaire de disposer d'un rayonnement de largeur spectrale inférieure à la largeur du niveau d'énergie étudié. C'est pour cela que toutes les sources laser accordables sont proposées avec une option d'affinement spectral. Une telle réduction spectrale peut être réalisée par l'invention.

Pour des études nécessitant une grande longueur de cohérence (interférométrie) ou une faible largeur spectrale (vélocimétrie) on est forcé d'affiner la raie d'émission du laser utilisé, qui en général est fixe mais trop large. Par exemple, dans le cas des lasers Nd:YAG impulsionnels, on utilise un second laser Nd:YAG continu monomode, dit "maître" qui sert d'injecteur au laser impulsionnel, dit "esclave" pour forcer l'émission de ce dernier à être monomode. L'invention présentée ici pourrait remplacer avantageusement cette solution complexe et coûteuse à mettre en oeuvre.

C'est un problème particulièrement sensible dans le cas des OPO. Leur raie d'émission a en effet une étendue spectrale de quelques nanomètres de large, en particulier lorsqu'ils ne sont pas injectés et surtout lorsque ils fonctionnent au voisinage de la dégénérescence. En effet, dans ce cas, la condition d'accord de phase est large. De telles sources gagneraient à être affinées. L'affinement spectral est généralement obtenu à l'aide de réseaux de diffraction qui pourraient être remplacés par le filtre spectral auto adaptatif.

Une géométrie utile à la compréhension de l'invention est représentée sur la figure 9. La cavité résonante est constituée du miroir 31 et du coupleur 32. Les miroirs 33 et 4 situés hors de cette cavité permettent de renvoyer le faisceau émis sur le cristal photoréfractif. Ce faisceau interfère avec les faisceaux présents dans la cavité résonante pour inscrire un hologramme. Cet hologramme réinjecte de la lumière à partir du faisceau 35 dans la cavité principale. Avantageusement, un filtre spatial ou spectral, peut être inséré dans la cavité formée des miroirs 33 et 4 et du matériau photoréfractif pour assurer un filtrage supplémentaire ou une sélection de la longueur d'onde ou du mode spatial.

Il est possible également d'envisager de rendre monomodes des microlasers multimodes en y incluant l'invention.

Enfin il est parfaitement envisageable d'utiliser l'invention pour améliorer les qualités spatiales des diodes laser de puissance en réduisant la largeur spectrale.

Les applications concernent notamment le domaine des télécommunications pour l'émission en régime continu, pour la réalisation de source monomode évitant les sauts de mode.

## Revendications

1. Source de rayonnement lumineux cohérent de type laser comportant une cavité résonante, un milieu amplificateur (3) placé dans la cavité résonante et un matériau photosensible dynamique (1) placé dans la cavité résonante pour former un filtre spectral et/ou spatial auto-adaptable, **caractérisée en ce que** la cavité est une cavité laser en anneau et **en ce que** le matériau photosensible dynamique (1) est placé à l'intersection de deux faisceaux croisés.

2. Source de rayonnement lumineux cohérent de type laser selon la revendication 1 **caractérisée en ce que** le matériau photosensible dynamique (1) est sensible aux variations spatiales des caractéristiques d'illumination.

3. Source de rayonnement lumineux cohérent de type laser selon la revendication 1 ou 2 **caractérisée en ce que** le matériau photosensible dynamique (1) est un matériau homogène.

4. Source de rayonnement lumineux cohérent de type laser selon la revendication 1 ou 2 **caractérisée en ce que** le matériau photosensible dynamique (1) est un matériau structuré.

5. Source de rayonnement lumineux cohérent de type laser selon la revendication 1 ou 2 **caractérisée en ce que** le matériau photosensible dynamique (1) est constitué d'une pluralité de lames.

6. Source de rayonnement lumineux cohérent de type laser selon la revendication 1 ou 2 **caractérisée en ce que** le matériau photosensible dynamique (1) est placé entre le milieu amplificateur (3) et le miroir de sortie (2).

**7.** Source de rayonnement lumineux cohérent de type laser selon la revendication 3 ou 4 **caractérisée en ce que** le matériau photosensible dynamique (1) est constitué par un matériau photoréfractif.

**8.** Source de rayonnement lumineux cohérent de type laser selon la revendication 6 **caractérisée en ce que** le matériau photosensible dynamique (1) placé entre le milieu amplificateur (3) et le miroir de sortie (2) est un matériau photoréfractif.

**9.** Source de rayonnement lumineux cohérent de type laser selon la revendication 1 ou 2 **caractérisée en ce que** le matériau photosensible dynamique (1) placé à l'intersection des deux faisceaux croisés est un matériau photoréfractif.

**10.** Source de rayonnement lumineux cohérent de type laser selon l'une quelconque des revendications précédentes caractérisée en ce le matériau photosensible dynamique (1) est un matériau de transparence induite.

**11.** Source de rayonnement lumineux cohérent de type laser selon la revendication 1 **caractérisé en ce que** le matériau photosensible dynamique est constitué par un cristal photoréfractif de titanate de baryum.

**Patentansprüche**

**1.** Quelle kohärenter Lichtstrahlung, die aus einem Hohlraumresonator, einem in dem Hohlraumresonator angeordneten verstärkenden Medium (3) und einem in dem Hohlraumresonator angeordneten lichtempfindlichen Stoff (1) besteht, um einen Spektral- oder Raumfilter zu bilden, wobei der Hohlraum ein ringförmiger Laserhohlraum ist und wobei der dynamische lichtempfindliche Stoff (1) am Schnittpunkt von zwei gekreuzten Bündeln angeordnet ist.

**2.** Laserartige Quelle kohärenter Lichtstrahlung nach Anspruch 1, **dadurch gekennzeichnet, dass** der lichtempfindliche Stoff (1) auf räumliche Veränderungen der Beleuchtungseigenschaften reagiert.

**3.** Laserartige Quelle kohärenter Lichtstrahlung nach Anspruch 1 oder 2, **dadurch gekennzeichnet, dass** der dynamische lichtempfindliche Stoff (1) ein homogener Stoff ist.

**4.** Laserartige Quelle kohärenter Lichtstrahlung nach Anspruch 1 oder 2, **dadurch gekennzeichnet, dass** der dynamische lichtempfindliche Stoff (1) ein strukturierter Stoff ist.

**5.** Laserartige Quelle kohärenter Lichtstrahlung nach Anspruch 1 oder 2, **dadurch gekennzeichnet, dass** der dynamische lichtempfindliche Stoff (1) aus einer Vielzahl von Lamellen besteht.

**6.** Laserartige Quelle kohärenter Lichtstrahlung nach Anspruch 1 oder 2, **dadurch gekennzeichnet, dass** der dynamische lichtempfindliche Stoff (1) zwischen dem verstärkenden Medium (3) und dem Ausgangsspiegel (2) angeordnet ist.

**7.** Laserartige Quelle kohärenter Lichtstrahlung nach Anspruch 3 oder 4, **dadurch gekennzeichnet, dass** der dynamische lichtempfindliche Stoff (1) aus einem lichtbrechenden Stoff besteht.

**8.** Laserartige Quelle kohärenter Lichtstrahlung nach Anspruch 6, **dadurch gekennzeichnet, dass** der zwischen dem verstärkenden Medium (3) und dem Ausgangsspiegel (2) angeordnete dynamische lichtempfindliche Stoff (1) ein lichtbrechender Stoff ist.

**9.** Laserartige Quelle kohärenter Lichtstrahlung nach Anspruch 1 oder 2, **dadurch gekennzeichnet, dass** der am Schnittpunkt der zwei gekreuzten Bündel angeordnete dynamische lichtempfindliche Stoff (1) ein lichtbrechender Stoff ist.

**10.** Laserartige Quelle kohärenter Lichtstrahlung gemäß einem der vorhergehenden Ansprüche, **dadurch gekennzeichnet, dass** der dynamische lichtempfindliche Stoff (1) aus einem Stoff mit induzierter Durchlässigkeit besteht.

**11.** Laserartige Quelle kohärenter Lichtstrahlung nach Anspruch 1, **dadurch gekennzeichnet, dass** der dynamische lichtempfindliche Stoff aus einem lichtbrechenden Barium-Titanatkristall besteht.

**Claims**

**1.** Coherent laser type luminous radiation source comprising a resonant cavity, an amplifying medium (3) placed in the resonant cavity and a dynamic photo sensitive material (1) placed in the resonant cavity to perform a spectral filter and/or a self-adaptable spatial filter, **characterised in that** the cavity is a ring laser cavity and **in that** the dynamic photo sensitive material (1) is placed at the intersection of two cross beams.

**2.** Coherent laser type luminous radiation source according to claim 1, **characterised in that** the dynamic photo sensitive material (1) is sensitive to spatial variations of illumination characteristics.

**3.** Coherent laser type luminous radiation source according to claim 1 or 2, **characterised in that** the dynamic photosensitive material (1) is a homogeneous material.

4. Coherent laser type luminous radiation source according to claim 1 or 2, **characterised in that** the dynamic photosensitive material (1) is a structured material.

5. Coherent laser type luminous radiation source according to claim 1 or 2, **characterised in that** the dynamic photo sensitive material (1) is composed of a plurality of strips.

6. Coherent laser type luminous radiation source according to claim 1 or 2, **characterised in that** the dynamic photosensitive material (1) is placed between the amplifying medium (3) and the output mirror (2).

7. Coherent laser type luminous radiation source according to claim 3 or 4, **characterised in that** the dynamic photo sensitive material (1) is composed of a photo refractive material.

8. Coherent laser type luminous radiation source according to claim 5, **characterised in that** the dynamic photo sensitive material (1) placed between the amplifying medium (3) and the output mirror (2) is a photo refractive material.

9. Coherent laser type luminous radiation source according to claim 1 or 2, **characterised in that** the dynamic photo sensitive material (1) placed at the intersection of the two cross beams is a photo refractive material.

10. Coherent laser type luminous radiation source according to any of the previous claims, **characterised in that** the dynamic photosensitive material (1) is an induced transparency material.

11. Coherent laser type luminous radiation source according to claim 1, **characterised in that** the dynamic photo sensitive material is composed of a photo refractive crystal of barium titanate.

Figure 1

Figure 2

Fig. 3

Fig. 4

Fig. 5

Fig. 6

Fig. 7

Fig. 8

Fig. 9